# EUROPEAN PATENT SPECIFICATION

(11) **EP 0 599 539 B1**
(45) Date of publication and mention of the grant of the patent: **12.03.1997**
(21) Application number: 93309162.1
(22) Date of filing: 17.11.1993
(51) Int. Cl.: G03F 7/075, G03F 7/095, G03F 7/38

(54) **Method for forming a pattern by silylation**
Verfahren zur Herstellung eines Musters durch Silylierung
Méthode pour la formation de motifs par silylation

(30) Priority: 18.11.1992 KR 9221641
(43) Date of publication of application: 01.06.1994
(73) Proprietor: SAMSUNG ELECTRONICS CO., LTD., Suwon-city, Kyungki-do 441-373 (KR)
(72) Inventor: Kim, Cheol-hong, Na-302, Changwon Villa, Suwon-city, Kyungki-do (KR); Han, Woo-sung, 7-101, Dongnam Apt., Suwon-city, Kyungki-do (KR)
(74) Representative: Kyle, Diana

(56) References cited:
- EP-A- 0 198 215
- EP-A- 0 265 619
- DATABASE WPI Section Ch, Week 8648, Derwent Publications Ltd., London, GB; Class A89, AN 86-314502 & JP-A-61 231 549 (OKI ELECTRIC IND KK) 15 October 1986

## Description

### Background of the Invention

The present invention relates to a method for forming a pattern using a photoresist film in the manufacturing process of semiconductor device, and more particularly, to a method for forming a pattern which can be manufactured by using only the two layer photoresist film by silylating the photoresist film, having maintained the resolution increasing effect which is caused by a multi-layer resist film process (hereinafter, called "MLR" process).

In general, the thickness of the photoresist film which passes the upper part differs from that of the photoresist film which passes the lower part of the step, since the photoresist film passes through the step region when the photo-etching process is performed by depositing a photoresist film on the wafer. Accordingly, the thin photoresist film in the subsequent exposure process is excessively exposed while the thick photoresist film is insufficiently exposed. Therefore, during the development process, the line width of the resist pattern which passes the step remains varied. That is, the line width of the over-exposed resist pattern of the upper part of the step becomes much more narrower than that of the lower part exposed insufficiently. Accordingly, the variation of the line width described above can not be allowed for the wiring wherein the height of the step is close to the line width. In addition to this, the minimum resolution value is decreased due to the so-called standing wave effects in the thick-formed resist layer, and the reflective lower substrate also makes the resolution worse.

Meanwhile, when the thin resist film is used, the problem of the standing wave effect and the lowering of the resolution generated from the reflective substrate can be overcome. However, it is impossible to overcome the limitation of the step coverage.

To overcome the above problem, the so-called MLR processing is proposed. This processing combines the thick planarized resist layer and the thin image transcribing layer, thereby forming the resist pattern (see Silicon Processing for the VLSI Era, S.Wolf and R.N.Tauber, Vol.1, 1986, pp424).

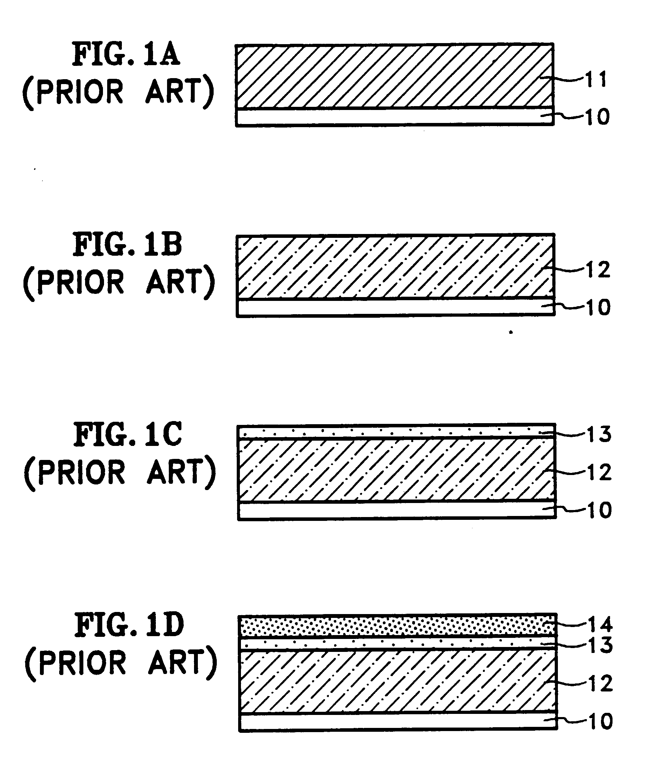

The conventional method for forming the pattern by the general MLR processing can be explained with reference to the attached FIGs.1A to 1H.

First, as shown in FIG.1A, a first photoresist layer 11 is formed on a wafer 10. Though wafer 10 is shown as flat, the surface of the wafer includes the various step region depending on the shape of the surface. The first photoresist layer 11 is formed thick enough to flatten this surface.

Then, as shown in FIG.1B, first photoresist layer 11 is neutralized, and is soft-baked on the hot plate for 1 minute or above at the temperature of 200-250°C, in order to vaporize the solvent in the resist. At this time, the resin component in first photoresist layer 11 and the photo active compound (PAC) are cross-linked, to thereby form a hardened first photoresist pattern 12.

Then, as shown in FIG.1C, an oxide film 13 is deposited thin on the hardened first photoresist layer 12. As a other method, the oxide film of silane (SiH₄) base is dispersed and spinned at the spin on glass (SOG) spin coater, and baked at a temperature of 200-240°C, thereby forming the oxide film 13.

Then, as shown in FIG.1D, a second photoresist layer 14 is deposited thin on the oxide film 13.

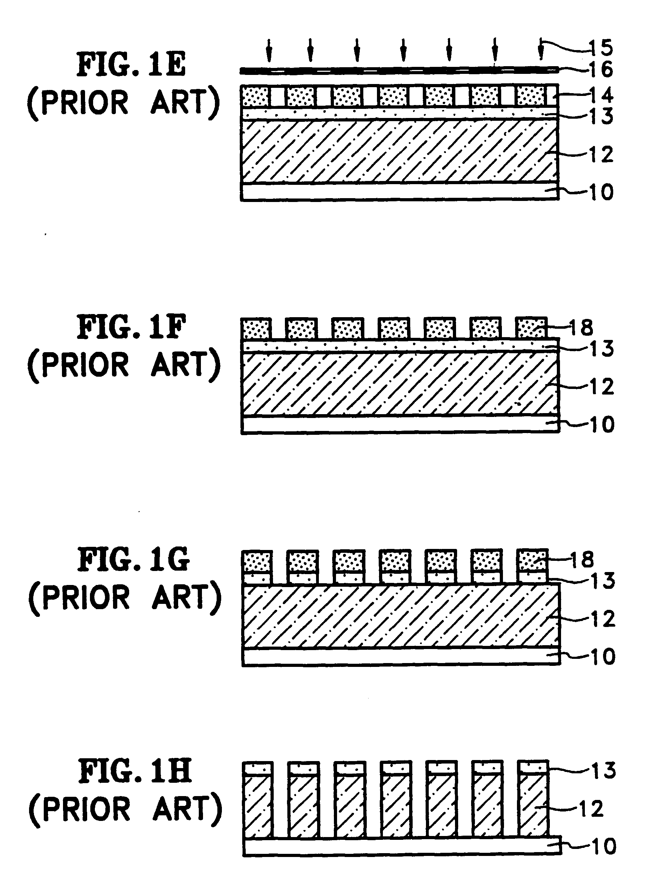

Then, as shown in FIG.1E, a ultra-violet light 15 is firstly irradiated to a photo mask 16 wherein the predetermined pattern is formed, and transcribes the pattern formed in photo mask 16 to second photoresist layer 14.

The PAC component of the region of second photoresist layer 14 lighted through photo mask 16 is destroyed, which then is washed by the developing solution in the subsequent development process.

As shown in FIG.1F, a second photoresist pattern 18 wherein only the portion of second photoresist layer 14 which is not irradiated to the ultra violet light 15 remains is formed by the development process.

Then, as shown in FIG.1G, an oxide film pattern is formed by etching an oxide film 13 formed in the lower part using second photoresist pattern 18 as an etching mask layer.

As shown in FIG.1H, first photoresist layer 12 is etched by using the pattern of oxide film 13 as an etching mask layer. As a result, a pattern consisting of the first photoresist layer 12 and oxide film 13 are formed on wafer 10.

A method for forming the pattern by the conventional MLR processing transcribes well the pattern of the photo mask, even for the wafer whose surface is extremely uneven. Therefore, the resolution is increased and the depth of focus becomes deeper, too.

However, for the conventional MLR processing, the resist has to be formed twice and the oxide film has to be formed as an intermediate layer, which requires a baking process done at a high temperature. Also, the facility for etching the oxide film is needed additionally. The addition of this complicated processing means that the productivity is lowered and the defect density is increased, and the cost is also increased.

Additionally, when the conventional MLR method is used, the by-products of the structure material such as a polysilicon layer, oxide film, or a metal layer formed on the wafer is attached to the sidewall of the resist in the course of etching the resist film. This by-products react with the resist, thereby forming a polymer. Thus-formed polymer remains even after the resist removing process is completed, and causes the defect.

### Summary of the Invention

It is an object of the present invention to provide a method for forming a pattern which improves the problem generated by the conventional MLR process, and provides a further simplified processing while retaining the resolution increasing effect, i.e., a merit of the method for forming a pattern by the conventional MLR processing, and decreases the defect caused by the polymer.

In order to accomplish the above object, there is provided a method for forming a pattern comprising the steps of:
forming a first photoresist layer on a substrate;
silylating the surface of said first photoresist layer to form a silylation layer;
forming a second photoresist layer on said silylation layer;
forming a pattern in said second photoresist layer by exposing and developing said second photoresist layer using a photo mask which is provided with a predetermined pattern;
etching back said silylation layer using said second photoresist pattern as an etching mask to form a silylation layer pattern while removing said second photoresist pattern;
oxidizing said silylation layer pattern; and
etching said first photoresist layer using said oxidized silylation pattern as an etching mask to form a first photoresist pattern.

According to the present invention, the intermediate oxide layer caused when a resist pattern is formed in the conventional MLR processing is not necessary and the patterned second photoresist (24a) is removed simultaneously with the formation of a silylation pattern (23a). As a result, the process for forming the pattern is simplified.

Additionally, when the silylation is oxidized, the oxide film wherein a lot of SiOₓ-structured organic matters are included, differently from the pure oxide silicon film SiO₂, is formed. Therefore, the polymer formed by the impurities decreases much when the lower substrate is etched using the first photoresist pattern.

### Brief Description of the Drawings

The above objects and other advantages of the present invention will become more apparent by describing in detail a preferred embodiment thereof with reference to the attached drawings in which:
FIGs.1A to 1H are cross-sectional views showing a method for forming the conventional multi-layer photoresist film pattern;
FIGs.2A to 2F are cross-sectional views showing an embodiment of the method for forming a two-layer photoresist film pattern according to the present invention;
FIG.3 is a chemical structural view showing the photoresist film, the silylation compounds thereof and the oxidized compounds according to the present invention.

### Detailed Description of the Invention

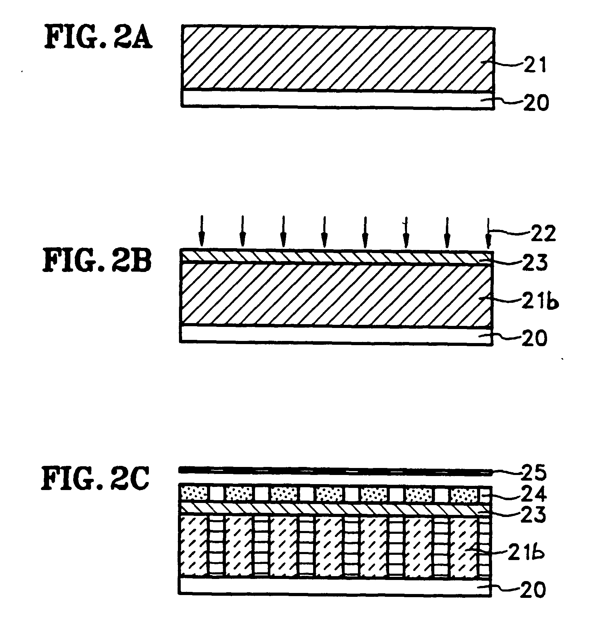

FIG.2A shows the step of forming a chemical amplification resist 21 on wafer 20. In general, wafer 20 has a uneven surface, however it is shown as planarized in FIG.2A. Chemical amplification resist 21 is added by an acid generator instead of the conventional photosensitive aid. There are two types of chemical amplification resist: posi-type and nega-type. Posi-type generates acid by an exposure, and this acid reacts with a base resin, which then forms an alkaline soluble body through baking process. In a nega-type resist, the acid react with a base resin by inserting a cross-linking material through baking process, which then forms an alkaline insoluble body, XP 89131 - 1.0µm resist of Shipley Co., i.e., a nega-type resist, is used for an embodiment of the present invention, as a chemical amplification resist.

FIG.2B shows the step of forming a silylation layer 23 by silylating the entire surface of chemical amplification resist layer 21b in a given thickness. Silylation process diffuses a silylating agent 22 which includes silicon to the organic compounds which includes an activation hydrogen ion (for example, -OH, -NH, -SH). At this time, the developing speed is changed since the diffusion region is hardened. As silylating agent 22, the present invention uses tetra-methyl disilazane (TMDS) which includes silicon, however, hexamethyl disilazane (HMDS), aminomethyltrimethylsilane (ATMS), dimethylsilyldimethylamine (DMSDMA), silane, etc., also can be used.

After all, resin which contains silicon is made from the substitutional reaction between silylating agent 22 and the hydrogen component of -OH radical in chemical amplification resist 21b. Accordingly, for the resists of such fields as novolac, polyvinylphenol besides the chemical amplification resist used for an embodiment of the present invention can be used, since hydrogen component of -OH radical and the silylating agent can be mutually substituted.

Meanwhile, the silylation condition for an embodiment of the present invention is that the TMDS is used in PLASMASTER-SI of JSR Co. as a silylation equipment, at a temperature of 120°C and for 110 seconds.

FIG.2C shows the step of forming a second photoresist layer 24 on silylation layer 23, and exposing second photoresist layer 24 through a photo mask 25 wherein the predetermined pattern is formed. Second photoresist 24 used for an embodiment of the present invention is ip-1800 of TOK Co.. The PAC component which exists in second photoresist 24 of the region where the light reaches through photo mask 25 is destroyed. At this time, first photoresist 21b below the silylation layer 23 is also reached by the light, thereby destroying PAC component. The exposure time is 600 msec.

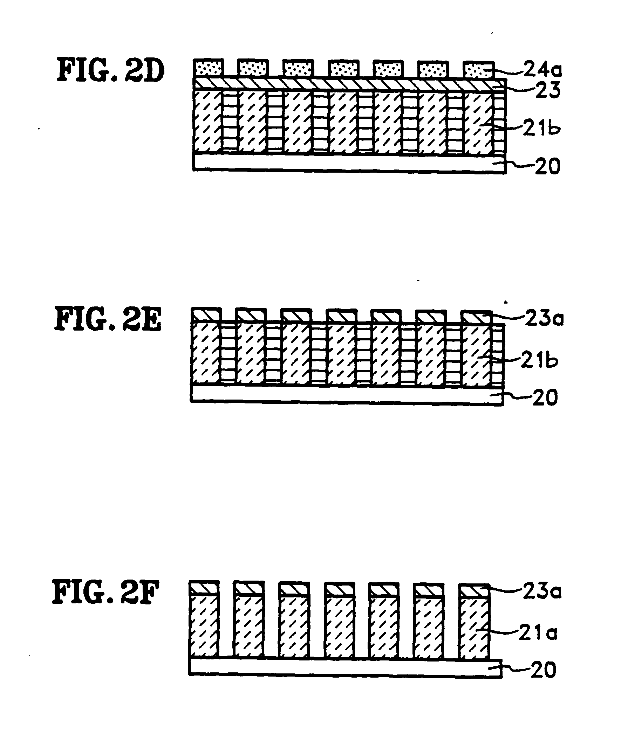

FIG.2D shows the step of forming a second photoresist pattern 24a formed by the remaining second photoresist layer of the region where the light doesn't reach, through the development process.

FIG.2E shows the step of forming a silylation layer pattern 23a by an etch-back process using second photoresist pattern 24a as an etching mask. The etch-back is performed under the condition that O₂ 5 sccm, N₂ 5 sccm and He 120 sccm, and RF electric power 2.0 Kw, and the time for 60 seconds. At this time, silylation layer 23 exposed below second photoresist pattern 24a when second photoresist pattern 24a is removed, is removed simultaneously, thereby forming a silylation layer pattern 23a.

FIG.2F shows the step of oxidizing silylation layer pattern 23a by use of an oxygen, and then, etching a first photoresist layer 21 using silylation layer pattern 23a changed to SiOₓ structure as an etching mask. As a result, a first photoresist pattern 21a is formed on wafer 20.

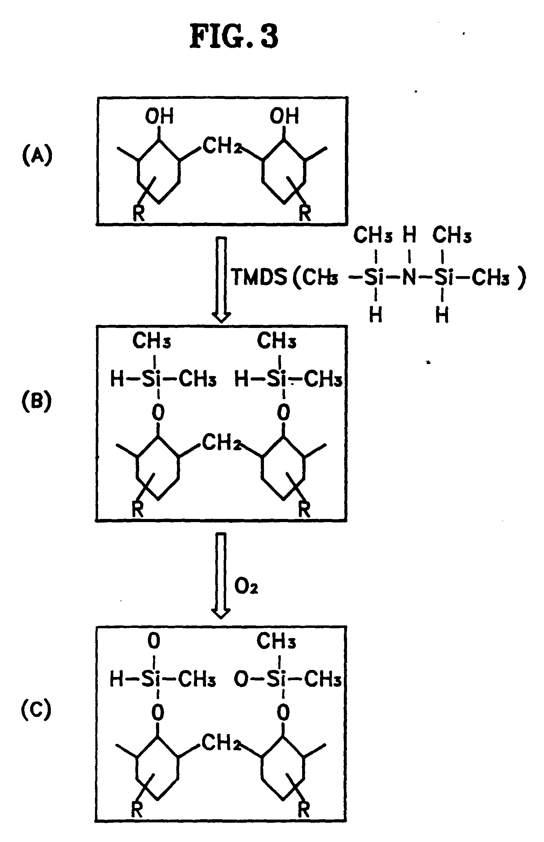

FIG.3 is a chemical structural view showing the silylation of the photoresist used for an embodiment of the present invention, and the oxidized compounds. Referring to FIG.3, (A) indicates a structure of the resin in the chemical amplification resist, and (B) is a structural view showing that the compounds silylated by putting the silylating agent TMDS used for an embodiment of the present invention into an reactor. (C) shows a structure of the resultant compound oxidizing the above silylated resist under the oxygen atmosphere.

As shown in the above described embodiment of the present invention, since the present invention use a single photoresist layer instead of the lower first photoresist layer and the intermediate oxide film required for the conventional MLR process for forming a pattern, the method for forming a pattern is simplified. In addition to this, since an oxide film which contains a lot of SiOₓ-structured organic substances as shown in (C) of FIG.3 is used in the present invention instead of the pure oxide film SiO₂ used for an intermediate film in the conventional method. Therefore, polymer formed by the impurities decreases when the lower substrate is etched. The experiment shows that the formation ratio of the polymer is decreased up to 1/10-1/100. Therefore, the lower resist layer can be completely removed, to thereby enable obtaining an element whose defect density is decreased.

It should be understood although preferred embodiments of the invention have been described in detail above, many modifications and variations could be effected therein by one with ordinary skill in the art without departing from the scope of the invention, as defined by the appended claims.

## Claims

1. A method for forming a pattern comprising the steps of:
forming a first photoresist layer (21) on a substrate (20);
silylating the surface of said first photoresist layer (21) to form a silylation layer (23);
forming a second photoresist layer (24) on said silylation layer (23);
forming a pattern (24a) in said second photoresist layer (24) by exposing and developing said second photoresist layer (24) using a photo mask (25) which is provided with a predetermined pattern;
etching back said silylation layer (23) using said second photoresist pattern (24a) as an etching mask to form a silylation layer pattern (23a) while removing said second photoresist pattern (24a);
oxidizing said silylation layer pattern (23a); and
etching said first photoresist layer (21) using said oxidized silylation pattern as an etching mask to form a first photoresist pattern (21a).

2. A method for forming a pattern according to claim 1, wherein said first photoresist layer (21) comprises an organic compound which can be silylated.

3. A method for forming a pattern according to claim 2, wherein said first photoresist layer (21) comprises any one selected from chemical amplification resist system, novolac based resist and polyvinylphenol based resist.

4. A method for forming a pattern according to claim 1, wherein said silylation step is performed by using as a silylating agent any one selected from tetra-methyl disilazane; hexamethyl disilazane; aminomethyltrimethylsilane; dimethylsilyldimethylamine; and silane.

## Patentansprüche

1. Verfahren zum Ausbilden des Musters, umfassend die Schritte des:
Ausbildens einer ersten Photoresistschicht (21) auf einem Substrat (20) ;
Silylierens der Oberfläche der ersten Photoresistschicht (21) zum Ausbilden einer Silylierungsschicht (23);
Ausbildens einer zweiten Photoresistschicht (24) auf der Silylierungsschicht (23) ;
Ausbildens eines Musters (24a) in der zweiten Photoresistschicht (24) durch Belichten und Entwickeln der zweiten Photoresistschicht (24) unter Verwendung einer Photomaske (25), welche mit einem vorbestimmten Muster versehen ist;
Rückätzens der Silylierungsschicht (23) unter Verwendung des zweiten Photoresistmusters (24a) als eine Ätzmaske zum Ausbilden eines Silylierungsschichtmusters (23a), während das zweite Photoresistmuster (24a) entfernt wird;
Oxidierens des Silylierungsschichtmusters (23a) ; und
Ätzens der ersten Photoresistschicht (21) unter Verwendung des oxidierten Silylierungsmusters als eine Ätzmaske zum Ausbilden eines ersten Photoresistmusters (21a).

2. Verfahren zum Ausbilden eines Musters gemäß Anspruch 1, worin die erste Photoresistschicht (21) eine organische Verbindung umfaßt bzw. enthält, welche silyliert werden kann.

3. Verfahren zum Ausbilden eines Musters gemäß Anspruch 2, worin die erste Photoresistschicht (21) irgendeine umfaßt, die ausgewählt ist aus einem chemischen Verstärkungsresistsystem, auf Novolak basierendem Resist und auf Polyvinylphenol basierendem Resist.

4. Verfahren zum Ausbilden eines Musters gemäß Anspruch 1, worin der Silylierungsschritt ausgeführt wird, indem als ein Silylierungsmittel irgendeines verwendet wird, das ausgewählt ist aus Tetramethyldisilazan; Hexamethyldisilazan; Aminomethyltrimethylsilan; Dimethysilyldimethylamin; und Silan.

## Revendications

1. Procédé pour former un motif, comprenant les étapes consistant à:
former une première couche de réserve (21) sur un substrat (20) ;
silyler la surface de ladite première couche de réserve (21) pour former une couche de silylation (23);
former une seconde couche de réserve (24) sur ladite couche de silylation (23);
former un motif (24a) dans ladite seconde couche de réserve (24) en exposant et en développant ladite seconde couche de réserve (24) en utilisant un photomasque (25) qui présente un motif prédéterminé;
soumettre ladite couche de silylation (23) à un mordançage par le côté dorsal en utilisant ledit second motif de réserve (24a) comme masque de mordançage pour former un motif de couche de silylation (23a) tout en éliminant ledit second motif de réserve (24a) ;
oxyder ledit motif de couche de silylation (23a) ; et
soumettre ladite première couche de réserve (21) à un mordançage en utilisant ledit motif de silylation oxydé comme masque de mordançage pour former un premier motif de réserve (21a).

2. Procédé pour former un motif selon la revendication 1, dans lequel ladite première couche de réserve (21) comprend un composé organique qui peut être silylé.

3. Procédé pour former un motif selon la revendication 2, dans lequel ladite première couche de réserve (21) comprend l'un quelconque d'un système de réserve sélectionné parmi une réserve par amplification chimique, une réserve à base de novolaque et une réserve à base de polyvinylphénol.

4. Procédé pour former un motif selon la revendication 1, dans lequel on effectue ladite étape de silylation en utilisant, comme agent de silylation, n'importe quel agent sélectionné parmi le tétraméthyldisilazane, l'hexaméthyldisilazane, l'aminométhyltriméthylsilane, la diméthylsilyldiméthylamine et le silane.
